(19) **Europäisches Patentamt / European Patent Office / Office européen des brevets**

(11) **EP 2 086 003 A2**

(12) # EUROPEAN PATENT APPLICATION

(43) Date of publication:
**05.08.2009 Bulletin 2009/32**

(51) Int Cl.:
**H01L 21/205** (2006.01)

(21) Application number: **09000807.9**

(22) Date of filing: **21.01.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **01.02.2008 JP 2008022939**

(71) Applicant: **Sumitomo Electric Industries, Ltd.**
**Osaka-shi,**
**Osaka 541-0041 (JP)**

(72) Inventors:
• **Nakamura, Takao**
  **Itami-shi**
  **Hyogo 664-0016 (JP)**

• **Ueno, Masaki**
  **Itami-shi**
  **Hyogo 664-0016 (JP)**
• **Ueda, Toshio**
  **Itami-shi**
  **Hyogo 664-0016 (JP)**
• **Takasuka, Eiryo**
  **Itami-shi**
  **Hyogo 664-0016 (JP)**
• **Senda, Yasuhiko**
  **Itami-shi**
  **Hyogo 664-0016 (JP)**

(74) Representative: **Grünecker, Kinkeldey,**
**Stockmair & Schwanhäusser**
**Anwaltssozietät**
**Leopoldstrasse 4**
**80802 München (DE)**

(54) **Method of growing group III-V compound semiconductor, and method of manufacturing light-emitting device and electronic device**

(57)    Provided are a method of growing a group III-V compound semiconductor, and method of manufacturing a light-emitting device and an electron device, in which risks are reduced and nitrogen can be efficiently supplied at low temperatures.

The method of growing a group III-V compound semiconductor includes the following processes. First, gas containing at least one selected from the group consisting of monomethylamine and monoethylamine is prepared as a nitrogen raw material. Then, the group III-V compound semiconductor is grown using the gas by vapor phase growth.

**FIG. 1**

S1 Preparation of at least one of monomethylamine and monoethylamine

S2 Preparation of ammonia

S3 Preparation of substrate

S4 Growth of group III-V compound semiconductor

EP 2 086 003 A2

**Description**

BACKGROUND OF THE INVENTION

1. Field of the Invention

The present invention relates to a method of growing a group III-V compound semiconductor, and a method of manufacturing a light-emitting device and an electron device.

2. Description of the Related Art

To date, group III-V nitride semiconductors containing GaN (gallium nitride), AlN (aluminum nitride), InN (indium nitride), a ternary mixed thereof, such as $Al_{(1-x)}Ga_xN$ (0 < x < 1) (hereinafter referred to as AlGaN), $In_{(1-x)}Ga_xN$ (0 < x < 1) (hereinafter referred to as InGaN), or $In_{(1-x)}Al_xN$ (0 < x < 1) (hereinafter referred to as AlInN), or a quaternary mixed, such as $In_{(1-x-y)}Al_xGa_yN$ (0 < x < 1, 0 < y < 1, x + y < 1) (hereinafter referred to as InAlGaN) have been utilized in blue light emitting diodes or white light emitting diodes (Light Emitting Diode: LED), blue-violet laser diodes (LD), etc. group III-V nitride semiconductors have been manufactured by vapor phase growth, such as OMVPE (Organo-metallic Vapor Phase Epitaxy). For example, OMVPE requires supply of group III elements such as Al (aluminium), Ga (gallium), and In (indium), and group V elements such as N (nitrogen). As a supply source of the group III elements such as Al, Ga, and In, a trialkyl compound has been used. Examples of the trialkyl compound include trimethylgallium ($(CH_3)_3Ga$: TMG), trimethylindium ($(CH_3)_3In$: TMI), and trimethylaluminum ($(CH_3)_3Al$: TMA). These compounds have a moderate vapor pressure or sublimability

Japanese Patent Application Publication No. H10-4211 (Patent Document 1) discloses a method of manufacturing a III-V group nitride semiconductor. According to the manufacturing method, ammonia ($NH_3$) has been used as a nitrogen (N) supply source.

Moreover, Japanese Patent Application Publication No. S61-241913 (Patent Document 2) and Japanese Patent Application Publication No. S63-103894 (Patent Document 3) disclose using hydrazine as a N supply source.

When a group III-V nitride semiconductor is grown in an active nitrogen-less environment, defects occurs inside or on the surface of a group III-V nitride semiconductor due to lack of N. Ammonia ($NH_3$) is generally used for producing a group III-V nitride semiconductor. $NH_3$ is heated to thermally decompose so that active N is generated in the environment where a group III-V nitride semiconductor grows. However, $NH_3$ requires a very high temperature for thermal decomposition due to its physical properties. Therefore, supplying N by using $NH_3$ results in low efficiency. Furthermore, it has been necessary that the V/III ratio is adjusted to be very high. In particular, in case of a group III-V nitride semiconductor containing In, its growth temperatures needs to be low. In conclusion, when a In-containing-nitride semiconductor is produced by using $NH_3$, In deficiency increases at relatively high temperature. Therefore it has been difficult to produce a high quality thin film having a high In composition by a process using $NH_3$.

Moreover, hydrazine can be used to supply active N, and be decomposed at lower temperatures compared with $NH_3$. However, hydrazine is explosive, and therefore growing a group III-V nitride semiconductor using hydrazine involves risk. Furthermore, hydrazine has had a problem in that hydrazine cannot be used together with stainless steel apparatus, because it easily decomposes upon contact with stainless steel. Moreover, hydrazine has higher toxicity than $NH_3$.

SUMMARY OF THE INVENTION

An object of the present invention is to provide a method of growing a group III-V compound semiconductor containing nitrogen which can reduce risks. During the process in the method, active N can be efficiently supplied at low temperatures. The present invention further provides a method of manufacturing a light-emitting device and an electron device.

The present inventors conducted extensive research in order to find a material which can reduce risks and efficiently supply N at low temperatures for the crystal growth of a group III-V compound semiconductor containing N. The present inventors found that the above-described problems can be overcome by using, as a N supply source, at least one selected from the group consisting of monomethylamine ($CH_3NH_2$) and monoethylamine ($C_2H_5NH_2$).

More specifically, the method of growing a group III-V compound semiconductor of the present invention is provided with the following processes. First, gas containing at least one selected from $CH_3NH_2$ and $C_2H_5NH_2$ is prepared as a N raw material (a process of preparing gas). Then, a group III-V compound semiconductor is grown using the gas by vapor phase growth (a process of growing a group III-V compound semiconductor).

According to the crystal growth method of the present invention, gas containing at least one selected from the group consisting of $CH_3NH_2$ and $C_2H_5NH_2$ is used as a N supply source. By using these gases as N supply source (as a group V raw material), active N can be efficiently supplied even at low temperatures, and the active N contributes to the growth.

Moreover, $CH_3NH_2$ and $C_2H_5NH_2$ do not have inflammability which is recognized in hydrazine. Therefore, they can secure the safety, and can be handled in the same way as ammonia ($NH_3$). The boiling points of $CH_3NH_2$ and $C_2H_5NH_2$ are 6.9°C and 38°C, respectively. Accordingly, $CH_3NH_2$ and $C_2H_5NH_2$ can be provided in the form of gas, and be safely and easily supplied.

In the crystal growth method of the present invention, it is preferable for a group III-V compound semiconductor to contain a group III-V nitride semiconductor.

Thus, by the use of gas containing at least one selected from $CH_3NH_2$ and $C_2H_5NH_2$ as a group V raw material, a group III-V nitride semiconductor can be grown at low temperatures.

In the crystal growth method of the present invention, vapor phase growth is preferably employed. The vapor phase growth method may be at least one selected from the group consisting of Organo-Metallic Vapor Phase Epitaxy (OMVPE), Hydride Vapor Phase Epitaxy (HVPE), and Molecular Beam Epitaxy (MBE).

By using the above-mentioned vapor phase growth method, a favorable group III-V compound semiconductor is easily grown so that it contains nitrogen.

In the crystal growth method of the present invention, The obtained group III-V compound semiconductor preferably contains indium (In).

In order to grow GaN, AlGaN, etc., with excellent crystallinity and optical properties, they need to be grown at a temperature of 1,000°C or higher.

In a nitride semiconductor containing In, In is weakly bonded to N.

Therefore, under high temperature conditions, such an In-containing-nitride semiconductor thermally decomposes, resulting in desorption of In and N. Accordingly, temperatures need to be maintained at low temperatures.

In the present invention, since active N can be supplied at low temperatures, N is not desorbed from a group III-V compound semiconductor.

Therefore, the present method may provide a high-quality group III-V compound semiconductor containing In.

The gas preparation process of the present invention preferably includes a step of preparing $NH_3$. Furthermore, the process of growing a group III-V compound semiconductor includes a step of supplying $NH_3$ at the time of supplying at least one selected from the group consisting of $CH_3NH_2$ and $C_2H_5NH_2$.

Thus, as an active N supply source, $NH_3$ and at least one of $CH_3NH_2$ and $C_2H_5NH_2$ can be supplied at once. Moreover, the N sources suitable for the type of thin film to be grown may be selected.

The method of growing a group III-V compound semiconductor comprises the process of preparing gas and the process of growing a group III-V compound semiconductor. The process of preparing gas preferably includes a step of preparing $NH_3$. The process of growing a group III-V compound semiconductor preferably includes a step of supplying at least one selected from $CH_3NH_2$ and $C_2H_5NH_2$ and a step of supplying $NH_3$. In this process, these steps are interchangeably performed.

Although N desorbs from the group III-V compound semiconductor at the time of supplying $NH_3$, this embodiment allows the desorbed N to be compensated. This compensation is achieved by supplying at least one selected from $CH_3NH_2$ and $C_2H_5NH_2$.

In the crystal growth method of the present invention, $CH_3NH_2$ and $C_2H_5NH_2$ each preferably contain $H_2O$ of 50 ppm or lower.

Because $CH_3NH_2$ and $C_2H_5NH_2$ contain low content of $H_2O$ as impurities, they can provide a group III-V compound semiconductor with more favorable crystallinity.

In the crystal growth method of the present invention, the gas preparation process preferably includes a step of removing $H_2O$ from $CH_3NH_2$ and $C_2H_5NH_2$.

According to this embodiment, $H_2O$ as impurities is removed from $CH_3NH_2$ and $C_2H_5NH_2$. $CH_3NH_2$ and $C_2H_5NH_2$ from after removal of $H_2O$ is capable of providing a group III-V compound semiconductor with more favorable crystallinity.

In another embodiment of the present invention, a group III-V compound semiconductor preferably contains a p-type semiconductor layer.

The contents of hydrogen (H) in $CH_3NH_2$ and $C_2H_5NH_2$ are lower than the content of H in $NH_3$. Low content of H results in a reduced generation of H (active hydrogen) which bonds to other atoms via dangling bond.

Moreover, the methyl group of $CH_3NH_2$ and $C_2H_5NH_2$ is easily bonded to active hydrogen to generate stable methane ($CH_4$). Accordingly, since incorporation of H into a group III-V compound semiconductor can be minimized, a bond between H and p-type impurities (typified by Mg) can be suppressed. Therefore, it is not necessary to perform annealing treatment for removing H from the crystal of a p-type group III-V nitride semiconductor layer. Thus, a p type semiconductor layer can be formed through the simplified formation process.

A method of manufacturing a light-emitting device of the present invention includes a stage of growing a group III-V compound semiconductor by any one of the methods of growing a group III-V compound semiconductor described above.

A method of manufacturing an electron device of the present invention includes a stage of growing a group III-V compound semiconductor by any one of the methods of growing a group III-V compound semiconductor described above.

According to the method of manufacturing a light-emitting device and an electron device of the present invention, their performance can be improved. This is because the devices are made of semiconductors containing sufficient contents of N. The semiconductors are produced by the methods of growing a group III-V compound semiconductor of the present invention.

According to the method of growing a group III-V compound semiconductor of the present invention and the method of manufacturing a light-emitting device and an electron device, nitrogen (N) can be supplied with reduced risk and at low temperatures.

BRIEF DESCRIPTION OF THE DRAWINGS

Figure 1 is a flowchart illustrating a method of growing a group III-V compound semiconductor according to Embodiment 1 of the present invention;

Figure 2 is a cross sectional view schematically illustrating a state where the group III-V compound semiconductor in Embodiment 1 of the present invention has been subjected to crystal growth;
Figure 3 is another flowchart illustrating a method of growing a group III-V compound semiconductor according to Embodiment 1 of the present invention;
Figure 4 is a cross sectional view schematically illustrating an LED according to Embodiment 2 of the present invention;
Figure 5 is a cross sectional view schematically illustrating an Schottky Barrier Diode (SBD) according to Embodiment 4 of the present invention;
Figure 6 is a cross sectional view schematically illustrating an High Electron Mobility Transistor (HEMT) according to Embodiment 5 of the present invention;
Figure 7 is a cross sectional view schematically illustrating a vertical transistor according to Embodiment 6 of the present invention; and
Figure 8 is a cross sectional view schematically illustrating an LD in Examples.

DESCRIPTION OF REFERENCE NUMERALS

| | |
|---|---|
| 101. | Substrate |
| 102. | Group III-V compound semiconductor |
| 200. | LED |
| 201, 301, 401, 501, 601. | Substrate |
| 202. | n-type buffer Layer |
| 203, 304. | Active layer |
| 204, 306. | p-type electron blocking layer |
| 205, 308. | p-type contact layer |
| 206, 309. | p-type electrode |
| 207, 310. | n-type electrode |
| 300. | LD |
| 302. | n-type cladding layer |
| 303, 305. | Undoped guide layer |
| 307. | p-type cladding Layer |
| 308. | p-type contact Layer |
| 400. | SBD |
| 402, 602. | Drift layer |
| 403. | Anode electrode |
| 404. | Cathode electrode |
| 500. | HEMT |
| 502. | Buffer Layer |
| 503. | Undoped GaN Layer |
| 504. | Undoped AlGaN Layer |

| 505, 606. | Source electrode |
|---|---|
| 506, 607. | Gate electrode |
| 507, 608. | Drain electrode |
| 600. | Transistor |
| 603. | Well region |
| 604. | Source region |
| 605. | Insulating Layer |

DETAILED DESCRIPTION OF THE INVENTION

(Embodiment 1)

Hereinafter, embodiments of the present invention will be described with reference to the drawings.

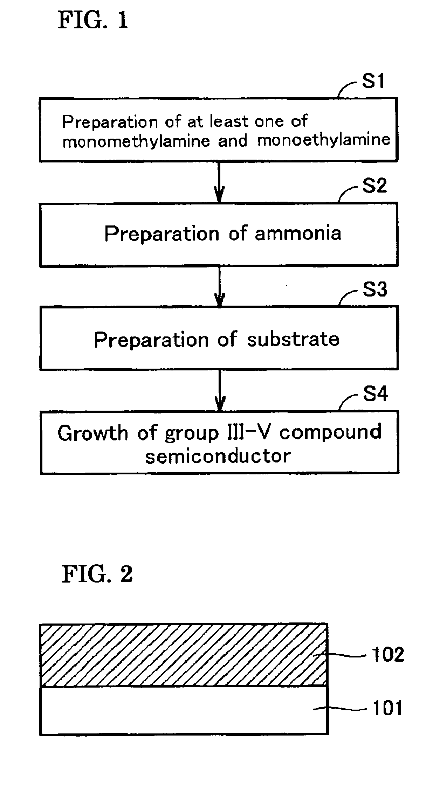

Figure 1 is a flowchart illustrating a method of growing a group III-V compound semiconductor according to this embodiment. Figure 2 is a cross sectional view schematically illustrating a structure of the group III-V compound semiconductor in this embodiment 1. With reference to Figs. 1 and 2, a method of growing a group III-V compound semiconductor will be described.

As illustrated in Fig. 1, at least one of $CH_3NH_2$ and $C_2H_5NH_2$ is prepared as a nitrogen (N) raw material (Step S1). $CH_3NH_2$ and $C_2H_5NH_2$ preferably have low impurity concentrations. For example, $CH_3NH_2$ and $C_2H_5NH_2$ originally contain high contents of $H_2O$. However, for this invention, it is preferable for them to each contain 50 ppm or lower. Thus, $H_2O$ is preferably removed from $CH_3NH_2$ and $C_2H_5NH_2$ to obtain the ones with a law content of $H_2O$. Specifically, the $H_2O$ may be removed by passing $CH_3NH_2$ and $C_2H_5NH_2$ through $H_2O$-removal filter.

As illustrated in Fig. 1, next, $NH_3$ is prepared as a N raw material (Step S2). It should be noted that Step S2 may be omitted.

During Step S1 of preparing at least one selected from $CH_3NH_2$ and $C_2H_5NH_2$ and Step S2 of preparing $NH_3$, the gas containing at least one selected from $CH_3NH_2$ and $C_2H_5NH_2$ can be prepared as a N raw material. It should be noted that another gas may be further contained.

Next, as illustrated in Figs. 1 and 2, a substrate 101 is prepared (Step S3). The substrate 101 may be formed using the same or different material as or from that of a group III-V compound semiconductor as mentioned later. The substrate 101 may be manufactured, using, for example, GaN (gallium nitride), GaAs (gallium arsenide), SiC (silicon carbide), sapphire, etc.

The substrate 101 has a surface for growing a group III-V compound semiconductor 102 mentioned later. The surface refers to a c-plane, an a-plane, an m-plane, etc. Then, an off-angle may be defined from these surfaces. It is preferable to use a semipolar GaN substrate and a nonpolar GaN substrate. These substrates can particularly reduce the influence of a piezoelectric field, and can grow a favorable crystalline group III-V compound semiconductor on the surface.

Next, as illustrated in Figs. 1 and 2, the group III-V compound semiconductor 102 is grown by vapor phase growth using the above-obtained gas (Step S4). By carrying out Step S4, the group III-V compound semiconductor 102 is grown on the substrate 101.

There is no limitation on the vapor phase growth method, but, for example, HVPE, MBE, OMVPE, etc., may be used. Furthermore, a plurality of these vapor phase growth methods may be used in combination.

Moreover, $CH_3NH_2$ and $C_2H_5NH_2$ and $NH_3$ may be used as a N supply source, or may be used as a group V raw material. Besides, $CH_3NH_2$ and $C_2H_5NH_2$ and $NH_3$ may be used as gas for doping as a n-type dopant. When gas of $CH_3NH_2$ and $C_2H_5NH_2$ or $NH_3$ is used as a group V raw material, a group III-V nitride semiconductor can be grown as the semiconductor 102.

The crystal growth method of this embodiment may includes Step S2 in which $NH_3$ is prepared. In this embodiment, $NH_3$ can be supplied at the time of supplying at least one selected from $CH_3NH_2$ and $C_2H_5NH_2$ in Step S4.

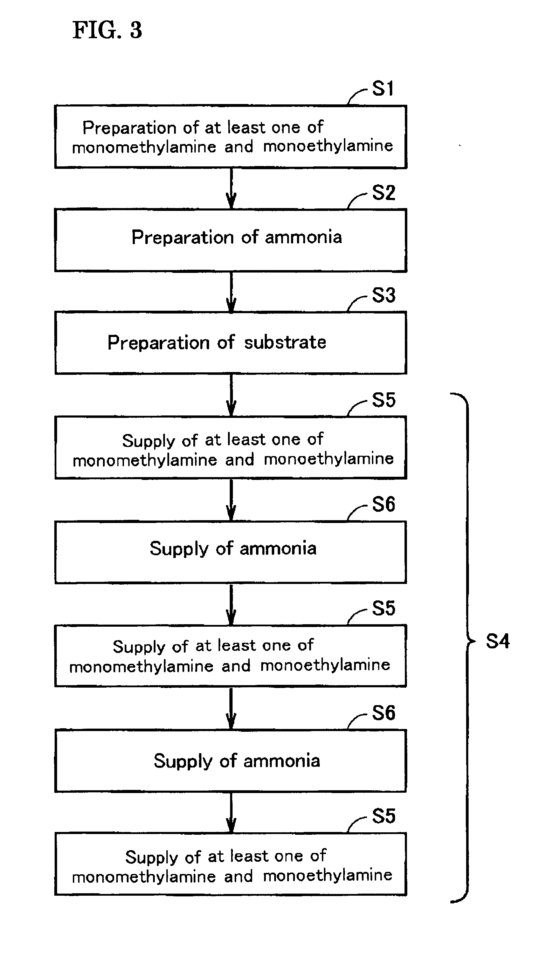

Figure 3 shows flowchart of another embodiment illustrating a method to grow a group III-V compound semiconductor. As illustrated in Fig. 3, in the crystal growth method of this embodiment, $NH_3$ is prepared in Step S2. The method may further comprise Step S5 of supplying at least one of $CH_3NH_2$ and $C_2H_5NH_2$, and Step S6 of supplying $NH_3$ wherein these steps may be interchangeably performed. In this embodiment, although N is desorbed in Step S6 (Step of supplying $NH_3$), N is compensated for in Step S5 (Step of supplying at least one of $CH_3NH_2$ and $C_2H_5NH_2$). Accordingly, it is preferable that Step S5 be a final step. Undergoing the steps 5 and 6, the group III-V compound semiconductor 102 can be grown. In this way in which at least one of $CH_3NH_2$ and $C_2H_5NH_2$ as well as $NH_3$ are supplied, $NH_3$ is prevented from reacting with another material gas. Therefore N is able to be continuously supplied.

It should be noted that the group III-V compound semiconductor 102 may be grown to have a single layer or a plurality of layers.

Moreover, the group III-V compound semiconductor 102 may contain a p-type semiconductor layer. When a p-type semiconductor layer is grown, it is preferable to use at least one selected from $CH_3NH_2$ and $C_2H_5NH_2$ as a N supply source. $CH_3NH_2$ and $C_2H_5NH_2$ contain lower contents of H than $NH_3$. Low content of H results in a reduced generation of H (active hydrogen) which bonds to other atoms via dangling bond.

Moreover, the methyl group of $CH_3NH_2$ and $C_2H_5NH_2$ is easily bonded to H to generate stable methane. Thus, H , which is incorporated into a semiconductor 102, preferentially bonds the methyl group. In the result, a bonds between the p-type impurities and the incorporated H can be suppressed. Accordingly, when the group III-V compound semiconductor 102 contains a p-type semiconductor layer, it is not necessary to perform annealing treatment for removing H from the p-type group III-V nitride semiconductor layer. Thus, the p type semiconductor layer can be produced by simplified formation process as mentioned above.

By carrying out Steps S1 to S6, the group III-V compound semiconductor 102 of this embodiment can be grown.

Hereinafter, effects of the method of growing the group III-V compound semiconductor 102 will be described.

First, in order to grow the group III-V compound semiconductor 102 containing N, it is necessary to decompose a N supply source. $NH_3$ has been conventionally used as a N supply source, and it is a stable substance. In order to break the bond between N and H to make N, NH, and $NH_2$ active and to provide with a dangling bond, high temperature heat needs to be applied. In case of a group III-V semiconductor, especially InGaN grown at high temperatures by OMVPE, active N can be efficiently and sufficiently generated. However, due to such high temperature conditions, In composition evaporates. As a result, an InGaN layer fails to take a required In composition. In particular, when the In composition is 15% or more, it is considerably difficult to grow InGaN. When growth temperature is lowered so as to increase the In composition, active N cannot be supplied, and therefore decomposition of InGaN cannot be suppressed. Because a part of In in InGaN aggregates as metal In, darkening proceeds due to the aggregation. When InGaN having a dark region is used for an active layer of a light-emitting device, the dark region becomes a non light-emitting area, causing a problem in that light is not emitted at all.

Then, the present inventors conducted extensive research on the active N supply source which can be decomposed at lower temperatures than $NH_3$. Finally, the present inventors found that so much amount of heat is not required for supplying active N if energy, which is required for decomposing the N supply source into $NH_2$ having a dangling bond, is low. As a result, the present inventors reached the conclusion that $CH_3NH_2$ and $C_2H_5NH_2$ are able to be preferably used as the N supply source.

When GaN is grown as the group III-V compound semiconductor 102, $NH_2$ is likely to react with Ga atoms present on the growth surface of GaN (e.g., S16 of Table 2 on page 375 of D. Sengupta et al., Journal of Crystal growth, Vol. 279 (2005) (hereinafter referred to as Nonpatent Document 1)). Therefore, on the growth surface of GaN as the group III-V compound semiconductor 102, $NH_2$ and Ga as the group III-V atom react with each other to generate surface-reacting-species-$GaNH_2$ (s) (e.g., S32 of Table 2 of Nonpatent Document 1). The $GaNH_2$ (s) is converted to complex intermediates, such as $MMG \cdot GaNH_2(s)$, $NH_3 \cdot MMG \cdot NH_2 \cdot Ga$ (s), $NH_2 \cdot Ga \cdot NH_2 \cdot Ga(s)$, $MMG \cdot NH_2 \cdot Ga \cdot NH_2 \cdot Ga$ (s), $NH_3 \cdot MMG \cdot NH_2 \cdot Ga \cdot NH_2 \cdot Ga(s)$, $NH_2 \cdot Ga \cdot NH_2 \cdot Ga NH_2 \cdot Ga$ (s), and (s) $NH_2 \cdot Ga \cdot NH_2 \cdot Ga \cdot NH_2 \cdot Ga$ (s), and $CH_4$ is emitted in the vapor phase (e.g., S20, S21, S22, S23, S24, S25, S12 of Table 2 of Nonpatent Document 1). Here, MMG in each chemical formula represents $GaCH_3$ and (s) represents surface-absorbed-species. The above-mentioned complex intermediates easily emit $H_2$ in the vapor phase to generate a GaN crystal on the surface (e.g., S13 of Table 2 of Nonpatent Document 1). Consequently, only N of $NH_2$ is incorporated into the group III-V nitride semiconductor, and H is desorbed from the group III-V nitride semiconductor.

The present inventors found through a simulation that;

1) monomethylamine($CH_3NH_2$) generates $NH_2$, NH, and $N_2$ having a dangling bond, and 2) the amounts of $NH_2$, NH, and $N_2$ generated from $CH_3NH_2$ is larger than that of $NH_2$, NH, and $N_2$ generated from ammonia. Each of $NH_2$, NH, and $N_2$ is active N source which contributes to the growth of the III-V group nitride semiconductor.

For the simulation, a commercially-available computational fluid dynamics(CFD) software was used. A gas flow equation for a reactor, an energy equation, and diffusion of gas species are all consistently solved by using the software.

Specifically, with respect to the reaction formulae shown in Table I, the frequency factor $A_0$, the temperature power n, and the activation energy $E_a$ are indicated. These constants are described in J. Cryst. Growth 253 (2003) 26., O. Danielsson and E. Janzen, J. Cryst. Growth 261 (2004) 204, J. R. Creighton, G. T. Wang, W. G. Breiland, M. E. Coltrin, etc.

[Table I]

| Reaction Formula | Frequency factor $A_0$ | Temperature power n | Activation energy Ea [kcal/mol] |
|---|---|---|---|
| $CH_3NH_2 + M \rightarrow CH_3 + NH_2 + M$ | $9.18 \times 10^{13}$ | 0 | 37.58 |
| $CH_3 + NH_2 \rightarrow CH_3NH_2$ | $7.15 \times 10^{12}$ | 0.42 | 0 |
| $NH_3 + M \leftrightarrow NH_2 + H + M$ | $3.60 \times 10^{19}$ | 0 | 93.8 |
| $NH_3 + H \leftrightarrow NH_2 + H_2$ | $5.40 \times 10^{5}$ | 2.4 | 9.92 |
| $2NH_2 \leftrightarrow N_2H_4$ | $2.00 \times 10^{46}$ | -10.93 | 10 |
| $2NH_2 \leftrightarrow NH_3 + NH$ | $5.00 \times 10^{13}$ | 0 | 9.94 |
| $NH_2 + NH \leftrightarrow NH_3 + N$ | $9.20 \times 10^{5}$ | 1.94 | 2.44 |
| $NH_2 + H \leftrightarrow NH + H_2$ | $4.80 \times 10^{8}$ | 1.5 | 7.94 |
| $NH_2 + N \leftrightarrow 2H + N_2$ | $7.10 \times 10^{12}$ | 0 | 0 |
| $NH + H \leftrightarrow H_2 + N$ | $3.50 \times 10^{12}$ | 0 | 1.73 |
| $2NH \rightarrow NH_2 + N$ | $5.96 \times 10^{2}$ | 2.89 | 0 |
| $NH + N \rightarrow H + N_2$ | $3.00 \times 10^{13}$ | 0 | 0 |
| $H + N_2 \rightarrow NH + H$ | $3.01 \times 10^{12}$ | 0.5 | 142 |
| $2H_2 \rightarrow 2H + H_2$ | $9.04 \times 10^{14}$ | 0 | 96.08 |
| $2H + H_2 \rightarrow 2H_2$ | $9.80 \times 10^{13}$ | -0.6 | 0 |
| $2H + M \leftrightarrow H_2 + M$ | $2.00 \times 10^{16}$ | 0 | 0 |

Next, in view of the reaction shown in Table I, the partial pressure of $NH_2$, NH, and $N_2$ generated from monomethylamine($CH_3NH_2$) and the partial pressure of $NH_2$, NH, and $N_2$ generated from ammonia ($NH_3$) were calculated using the following equation.

In detail, the diffusion equation (Equation 1) of each gas-reacting-species i in the gas flow was solved to calculate the distribution of each reacting-species.

[Equation 1]

$$\frac{\partial}{\partial t}(\rho Y_i) + \nabla \cdot (\rho v Y_i) = -\nabla \cdot J_i + R_i \qquad \cdots \text{Equation 1}$$

In Equation 1, $\rho$ represents the mass density [kg/m$^3$] of gas, $Y_i$ represents the mass concentration of the reacting-species i, v represents the flow rate [m/s] of gas, $J_i$ represents the diffusion flux of the reacting-species i, $R_i$ represents the generation rate of the species i [kg/m$^3$s] by the reactions per unit time.

$J_i$ was calculated using Equation 2.

[Equation 2]

$$J_i = -\rho D_{i,m} \nabla Y_i \qquad \cdots \text{Equation 2}$$

In Equation 2, $D_i$,m represents the diffusion coefficients of the reacting-species i in a mixed gas. $R_i$ was calculated using Equation 3.

**[Equation 3]**

$$R_i = M_{w,i} \sum_{r=1}^{N_R} \hat{R}_{i,r} \qquad \text{••• Equation 3}$$

In Equation 3, $M_{w,i}$ represents the molar weight [kg/kgmol] of the reacting-species i, $R_{i,r}$ represents the molar generation rate [kgmol/m$^3$s] of the reacting-species i by the reaction r, and $N_R$ represents the total number of the reaction formulae to be considered.

When N reactions to be considered are represented by Equation 4, the reaction generation rate $R_{i,r}$ was calculated using (Equation 5).

**[Equation 4]**

$$\sum_{i=1}^{N} v'_{i,r} M_i \underset{k_{b,r}}{\overset{k_{f,r}}{\rightleftharpoons}} \sum_{i=1}^{N} v''_{i,r} M_i \qquad \text{••• Equation 4}$$

**[Equation 5]**

$$R_{i,r} = \Gamma(v''_{i,r} - v'_{i,r})\left( k_{f,r} \prod_{j=1}^{N_r} [C_{j,r}]^{\eta'_{j,r}} - k_{b,r} \prod_{j=1}^{N_r} [C_{j,r}]^{\eta''_{j,r}} \right) \qquad \text{••• Equation 5}$$

In Equations 5 and 6, $v'_{i,r}$ represents the stoichiometry with which the reacting species i contribute in the forward direction reaction of the reaction r, $v''_{i,r}$ represents the stoichiometry with which the reacting species i contribute in the reverse direction reaction of the reaction r, $M_i$ represents the chemical formula of the reacting species i, $\Gamma$ represents effects of a third body molecule, $k_{f,r}$ represents the reaction constant of the forward direction reaction of the reaction r, $k_{b,r}$ represents the reaction constant of the reverse direction reaction of the reaction r, Nr represents the total number of reacting-species which participate in the reaction r, $[C_{j,r}]$ represents the molar concentration [kgmol/m$^3$] of the reacting species j which participate in the reaction r, $\eta'_{j,r}$ represents the reaction order of the reacting species j of the forward reaction of the reaction r, $\eta''_{j,r}$ represents the reaction order of the reacting species j of the reverse reaction of the reaction r.

The effects of a third body molecule $\Gamma$ were calculated using Equation 6.

**[Equation 6]**

$$\Gamma = \sum_{j}^{N_r} \gamma_{j,r} C_j \qquad \cdots \text{Equation 6}$$

In Equation 6, $\gamma_{j,r}$ represents the coefficient of the effects of the third body in the reaction r of the reacting-species j. In the equations including "+M" in Table I for the reacting-species which participate in the reaction r, $\gamma_{j,r}$ was defined as 0, and for the other species, $\gamma_{j,r}$ was defined as 1. $C_j$ represents the molar fraction of the reacting-species j.
The reaction constant $k_{f,r}$ in the forward direction reaction of the reaction r was calculated using the Arrhenius form equation (Equation 7).
**[Equation 7]**

$$k_{f,r} = A_r T^{\beta_r} e^{-E_r/R_r} \qquad \cdots \text{Equation 7}$$

In Equation 7, $A_r$ represents the frequency factor of the reaction r, T represents the absolute temperature [K], $\beta_r$ represents the temperature power constant of the reaction r, $E_r$ represents the activation energy [kcal/mol] of the reaction r, and R represents the gas constant [kcal/molK]. The constants of the reaction r are shown in Table I.
The reaction constant $k_{b,r}$ in the reverse direction reaction of the reaction r was calculated using Equation 8.
**[Equation 8]**

$$k_{b,r} = \frac{k_{f,r}}{k_r} \qquad \cdots \text{Equation 8}$$

In Equation 8, $K_r$ represents the equilibrium constant of the reaction r, which was calculated using Equation 9.
**[Equation 9]**

$$k_r = \exp\left(\frac{\Delta S_r^0}{R} - \frac{\Delta H_r^0}{RT}\right)\left(\frac{p_{atm}}{RT}\right)^{\sum_{r=1}^{N_R}(v_{j,r}'' - v_{j,r}')} \qquad \cdots \text{Equation 9}$$

In Equation 9, $\Delta S_r^0$ represents the change in the total standard entropy of the reaction r, $\Delta H_r^0$ represents the change in the total standard enthalpy of the reaction r, and $p_{atm}$ represents the atmospheric pressure (101314 Pa). $\Delta S_r^0$ was calculated using Equation 10.
[Equation 10]

$$\frac{\Delta S_r^0}{R} = \sum_{i=1}^{N} (v_{i,r}'' - v_{i,r}') \frac{S_i^0}{R}$$ ••• Equation 10

In Equation 10, $S^0$ represents the standard entropy of the reacting-species i. $\Delta H^0_r$ was calculated using Equation 11.
[Equation 11]

$$\frac{\Delta H_r^0}{RT} = \sum_{i=1}^{N} (v_{i,r}'' - v_{i,r}') \frac{h_i^0}{RT}$$ ••• Equation 11

In Equation 11, $h_i^0$ represents the standard enthalpy of the reacting-species i. The Navier-Stokes equation and the equation of continuity were solved. All the equations were solved utilizing the finite-volume method.
Here, the volume of the reactor was 380 $cm^3$, the temperature in the reactor was 775°C, the pressure of the reactor was 101 kPa, the flow rate of monomethylamine($CH_3NH_2$) or ammonia($NH_3$) was 30 SLM, and the flow rate of nitrogen (N) was 100 SLM. The results are shown in Table II. In Table II, the unit of the partial pressure of each of $NH_2$, NH, and $N_2$ generated from monomethylamine and ammonia is Pa.
[Table II]

|  | Monomethylamine | Ammonia |
|---|---|---|
| $NH_2$ | 5. 07 $\times$ 10<sup>-1</sup> | 1. 87 $\times$ 10<sup>-5</sup> |
| NH | 6. 27 $\times$ 10<sup>-3</sup> | 3. 24 $\times$ 10<sup>-9</sup> |
| N | 9. 30 $\times$ 10<sup>-1</sup> | 4. 92 $\times$ 10<sup>-5</sup> |

As shown in Table II, the partial pressure of $NH_2$ generated from monomethylamine ($CH_3NH_2$) was higher than that of $NH_2$ generated from ammonia($NH_3$). In view of the above result, when the same amount of heat is applied to $CH_3NH_2$ and $NH_3$, $CH_3NH_2$ can generate a larger amount of $NH_2$ having a dangling bond than $NH_3$.
The results of the simulation show that $CH_3NH_2$ can efficiently generate active N source which contributes to the growth of the group III-V compound semiconductor because $CH_3NH_2$ can generate a larger amount of $NH_2$ as the active N source than $NH_3$.
Moreover, $CH_3NH_2$ and $C_2H_5NH_2$ can generate $NH_2$ having a dangling bond with the small amount of energy required for breaking a bond between N and C in the vapor phase. Therefore, $CH_3NH_2$ and $C_2H_5NH_2$ are very effective as the N supply source.
GaN crystal is grown at 800°C. In contrast, InN sublimates at 620°C.
When $NH_3$ is used as the N supply source, a temperature of 800°C or higher is required to decompose $NH_3$ into N, NH, or $NH_2$, each of which has a dangling bond. The N, NH, or $NH_2$ contributes to actual favorable crystal growth. In contrast, $CH_3NH_2$ and $C_2H_5NH_2$ are efficiently decomposed into $NH_2$ and a methyl group ($CH_3$) in the vapor phase by, for example, applying heat of 500°C or higher. The generated $NH_2$ and a methyl group ($CH_3$) contribute to actual favorable crystal growth. In conclusion, the N supply source can be supplied at a temperature lower than the sublimation temperature of the group III-V compound semiconductor 102.

As mentioned above, $In_{(1-x)}Ga_xN$ may be grown as the group III-V compound semiconductor 102 by supply with $CH_3NH_2$ and $C_2H_5NH_2$ to generate $NH_2$. In this embodiment, $NH_2$ and In react with each other to generate $InNH_2$ (s) on the growth surface of the group III-V compound semiconductor 102. $H_2$ is desorbed from $InNH_2$ (s) via a complex intermediate.

Therefore, even in the case where the group III-V compound semiconductor containing In which is weakly bonded to N, N can be incorporated into its growth surface. This is because heat applied for supplying N is not so high, and such a less heat prevents the already-incorporated In from desorbing from InGaN. Accordingly, the heat applied for supplying N can be lowered, N is not desorbed from the growth surface of InGaN, and the aggregation of In can be inhibited. As a result, the dark area can be reduced in the growth of the group III-V compound semiconductor 102, and therefore nonradiative area therein is reduced. Further the luminous efficiency of the semiconductor 102 can be improved. The obtained $In_{(1-x)}Ga_xN$ may be used for the active layer of a light-emitting device, because it contains an increased mixed crystal ratio x of In.

Furthermore, since active N can be efficiently supplied at low temperatures, N is prevented from being introduced insufficiently in the group III-V compound semiconductor 102. Therefore, crystal defects, which is caused by insufficiency of N, can be inhibited on the semiconductor 102 so that a n-type carrier is not induced.

As mentioned above, a favorable growth can be maintained due to sufficient quantities of N. When the p-type group III-V compound semiconductor 102 is grown according to the present invention, the p-type carrier concentration is not decreased.

(Embodiment 2)

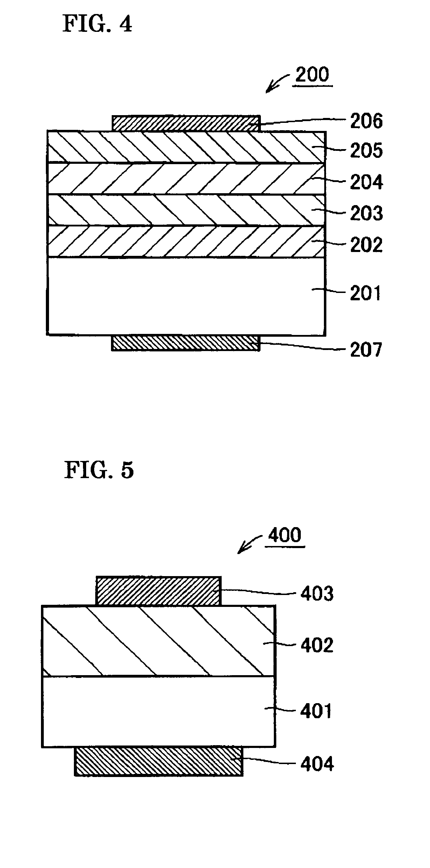

Figure 4 is a cross sectional view illustrating another embodiment of an LED (Light Emitting Diode) as a light-emitting device. With reference to Fig. 4, the LED will be described. An LED 200 is provided with a substrate 201, a n-type buffer layer 202, an active layer 203, a p-type electron blocking layer 204, a p-type contact layer 205, a p-type electrode 206, and a n-type electrode 207. The n-type buffer layer 202, the active layer 203, the p-type electron blocking layer 204, and the p-type contact layer 205 form the group III-V compound semiconductor layer.

The substrate 201 is a n-type GaN substrate, for example. The n-type buffer layer 202 is formed on the substrate 201, has a thickness of, for example, 2 $\mu$m, and contains a n-type GaN. The active layer 203 is formed on the n-type buffer layer 202 and is formed of a multiple quantum well structure. The multiple quantum well structure comprises InGaN and GaN, in which InGaN has a thickness of 3 nm and GaN has a thickness of 15 nm. The active layer 203 may be formed of a single semiconductor material. The p-type electron blocking layer 204 is formed on the active layer 203, has a thickness of, for example, 20 nm, and contains p-type AlGaN (aluminum gallium nitride). The p-type contact layer 205 is formed on the p-type electron blocking layer 204, has a thickness of, for example, 50 nm, and contains p-type GaN.

The p-type electrode 206 is formed on the p-type contact layer 205 and contains, nickel (Ni), gold (Au), etc. The n-type electrode 207 is formed on a surface of the substrate 201 opposite to the surface thereof on which the n-type buffer layer 202 has been formed. The n-type electrode 207 contains titanium (Ti), aluminum (Al), etc.

Then, a method of manufacturing the LED 200 of this embodiment will be described with reference to Fig. 3. Specifically, first, at least one selected from $CH_3NH_2$ and $C_2H_5NH_2$ is prepared as a N raw material (Step S1). Next, $NH_3$ is prepared as required (Step S2). During the steps, gas containing at least one of $CH_3NH_2$ and $C_2H_5NH_2$ as a N raw material can be prepared. Since Steps S1 and S2 are the same as in Embodiment 1, the descriptions thereof are not repeated.

Next, a substrate is prepared (Step S3). In this embodiment, the substrate 201, such as a n-type GaN substrate, is prepared, for example. According to this embodiment, LED 200 may be produced.

Next, the group III-V compound semiconductor is grown by vapor phase growth using the above-prepared gas (Step S4). The vapor phase growth method is not limited, but OMVPE is preferably employed.

Specifically, using an organic metal as a group III elements-containing-raw material and the above-prepared gas as a group V raw material, the n-type buffer layer 202, the active layer 203, the p-type electron blocking layer 204, and the p-type contact layer 205 are grown on the substrate 201 in the stated order. When a n-type or p-type group III-V compound semiconductor is grown, a raw material containing n-type impurities or a raw material containing p-type impurities is used together with an organic metal as a raw material of group III elements and a group V raw material under the conditions where a desired n-type or p-type carrier concentration is achieved. As the organic metal, TMG, TMI, TMA, etc., can be used. As the n-type impurity, silane can be used, for example. As the p-type impurity, bis cyclopentadienyl magnesium can be used, for example. As the carrier gas, nitrogen, hydrogen, etc., can be used.

It should be noted it is preferable that the active layer 203 be grown at 600°C to 700°C and that the In composition contain 25% to 35% GaN. This composition can provide green light emission.

In the following step, the p-type electrode 206 is formed on the p-type contact layer 205. The p-type electrode 206 may be an electrode in which Ni, Au, etc., are layered. The electrode 206 may be formed by vacuum deposition.

Next, a n-type electrode 207 is formed on a surface of the substrate 201 opposite to the surface thereof on which the n-type buffer layer 202 has been formed. The electrode may have a layered structure comprising Ti, Al, etc., In this step, the electrode may be formed by vacuum deposition.

The LED 200 shown in Fig. 4 can be manufactured by carrying out the above-described steps (S1 to S4). It should be noted that, in Step S4 of growing the group III-V compound semiconductor, $NH_3$ may be supplied as a group V raw material at the time of supplying at least one selected from $CH_3NH_2$ and $C_2H_5NH_2$. Alternatively, Step S4 may include Step S5 of supplying at least one selected from $CH_3NH_2$ and $C_2H_5NH_2$ as a group V raw material and Step S6 of supplying $NH_3$, in which the two steps may be interchangeably performed.

As described above, according to the LED 200 and the method of manufacturing the LED 200 in this embodiment, at least one selected from $CH_3NH_2$ and $C_2H_5NH_2$ is supplied as a V group raw material, and thus a V group raw material can be supplied at low temperatures. Therefore, the group III-V nitride semiconductor containing In can be grown at low temperatures so that In is not desorbed from the growth surface When the LED 200 is provided with an active layer containing InGaN having an In composition of 32% to 35%, for example, a green LED can be manufactured. Furthermore, even if the supply amount of group V elements is smaller than that of $NH_3$, a high-quality InGaN crystal can be grown.

(Modification Example)

This modification example is the same as the embodiments described above except that the LED 200 is manufactured by MBE. When MBE is employed, a metal, such as Ga, In, or Al is used as group III elements and a metal, such as Si or Mg is used as a dopant. As a group V element, at least one selected from $CH_3NH_2$ and $C_2H_5NH_2$ may be used. Alternatively, at least one selected from $CH_3NH_2$ and $C_2H_5NH_2$ may be mixed with $NH_3$ for use. According to MBE, growth occurs in a thermal non-equilibrium ground unlike OMVPE, and the crystal growth at lower temperatures becomes possible. Therefore, MBE allows crystal growth of a higher In composition compared with OMVPE, and an active layer containing InGaN to have an In composition of 25 to 65%.

(Embodiment 3)

A manufacturing method will be described in which an LED in this embodiment is converted into a p-type device without heat treatment after epitaxial growth.

Specifically, the LED 200 in this embodiment contains the group III-V semiconductor layer having the same structure as that shown in Fig. 4 described in Embodiment 2.

In this embodiment shown in Fig. 4, when a p-type semiconductor layer is grown by doping bis cyclopentadienyl magnesium, at least one selected from $CH_3NH_2$ and $C_2H_5NH_2$ is used as the N supply source, without supplying $NH_3$. The supply amounts of $CH_3NH_2$ and $C_2H_5NH_2$ may be smaller than that of $NH_3$. Moreover, $CH_3NH_2$ and $C_2H_5NH_2$ each contain a relatively-small amount of H. Accordingly, using $CH_3NH_2$ and $C_2H_5NH_2$ can prevent generation of H which has a dangling bond. H having the dangling bond is likely to bind to other atoms. According to this embodiment, the methyl groups of $CH_3NH_2$ and $C_2H_5NH_2$ are likely to bind to H so that stable methane is generated, and thus H is not incorporated into a p-type semiconductor layer. Therefore, in this embodiment, because Mg is not bonded to H, Mg is effectively activated.

When $NH_3$ is used as the N supply source, bonding between Mg and H is broken by heat treatment after epitaxial growth, and then Mg is activated. In the case where at least one selected from $CH_3NH_2$ and $C_2H_5NH_2$ is used as the N supply source, a p-type semiconductor layer can be formed without heat treatment, in which the layer contains H and Mg as p-type impurities.

(Embodiment 4)

Figure 5 is a cross sectional view schematically illustrating another embodiment of an SBD (Schottky Barrier Diode) as an electron device.

An SBD in this embodiment will be described with reference to Fig. 5. As shown in Fig. 5, the SBD 400 in this embodiment is provided with a substrate 401, a drift layer 402, an anode electrode 403, and a cathode electrode 404.

The substrate 401 is, for example, a n-type GaN substrate. The drift layer 402 is formed on the substrate 401. The layer 402 has a thickness of 5 $\mu$m and contains a n-type GaN, for example. The anode electrode 403 is formed on the drift layer 402 and is a Schottky electrode containing gold, for example. The cathode electrode 404 is formed on a surface of the substrate 401 opposite to the surface thereof on which the drift layer 402 has been formed. The electrode 404 is an ohmic electrode in which Ti, Al, Ti, and Au have been layered in the stated order, for example.

Then, with reference to Fig. 5, a method of manufacturing the SBD 400 in this embodiment will be described. Specifically, first, at least one selected from $CH_3NH_2$ and $C_2H_5NH_2$ is used as a N raw material (Step S1). Next, $NH_3$ is prepared as required (Step S2). During the steps, gas containing at least one selected from $CH_3NH_2$ and $C_2H_5NH_2$ as a N raw material can be prepared. Since Steps S1 and S2 are the same as in Embodiments 1 to 3, the descriptions thereof are not repeated.

Next, a substrate is prepared (Step S3). In this embodiment, the substrate 401, such as a n-type GaN substrate, is prepared as the substrate, for example. According to this embodiment, SBD 400 may be produced.

Next, the group III-V compound semiconductor is grown using the above-prepared gas by vapor phase growth (Step S4). In this embodiment, the group III-V compound semiconductor is grown using at least one of $CH_3NH_2$ and $C_2H_5NH_2$ as a group V raw material. This semiconductor is formed by growing the drift layer 402 containing n-type GaN, for example. The vapor phase growth method is not limited, but OMVPE, for example, can be applied as in Embodiments 2 and 3. At the time of growth of the drift layer 402, silane is simultaneously supplied as n-type impurities.

Next, the anode electrode 403 is formed on the drift layer 402. In this step, an electrode containing, for example, gold is formed by vacuum deposition.

Next, the cathode electrode 404 is formed on a surface of the substrate 401 opposite to the surface thereof on which the drift layer 402 has been formed. In this step, an electrode, in which Ti, Al, etc., have been layered, is formed by vacuum deposition.

By carrying out the above-mentioned steps (S1 to S4), the SBD 400 shown in Fig. 5 can be manufactured. When $NH_3$ is used, N loss is likely to occur in the drift layer 402. Thus, there has been a problem in that an increase in leakage current arises and reliability cannot be secured.

In contrast, by the above-described steps of this embodiment, occurrence of N loss is inhibited. Thus, leakage current can be reduced and reliability can be improved. Moreover, in producing an SBD required to have a thick film, the supply amount of the group V elements can be reduced, resulting in advantages in cost for a raw material, elimination, etc.

(Embodiment 5)

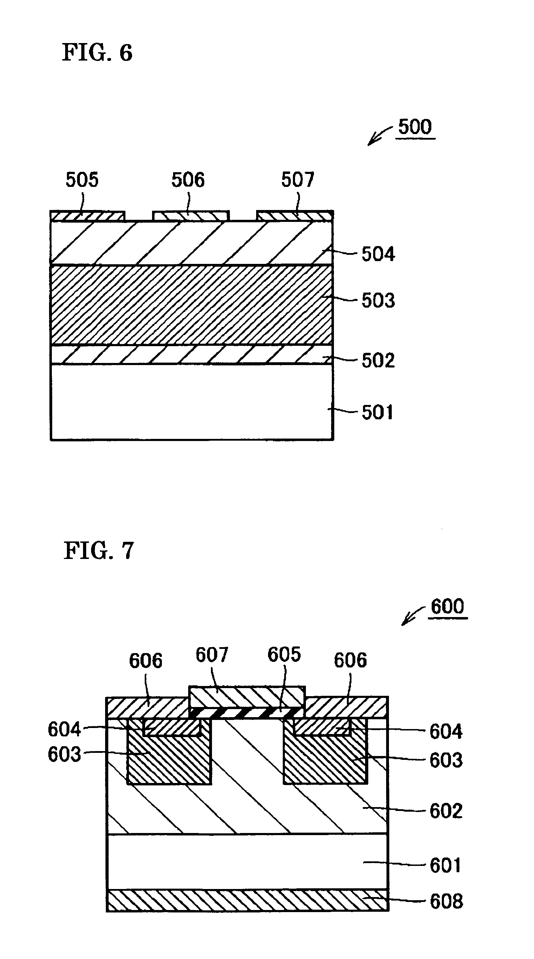

Figure 6 is a cross sectional view illustrating an HEMT as an electron device in this embodiment. As shown in Fig. 6, an HEMT 500 in this embodiment is provided with a substrate 501, a buffer layer 502, an undoped GaN layer 503, an undoped AlGaN layer 504, a source electrode 505, a gate electrode 506, and a drain electrode 507.

The substrate 501 is a sapphire substrate, for example. The buffer layer 502 is formed on the substrate 501. The layer 502 has a thickness of 30 nm, for example and contains GaN. The undoped GaN layer 503 is formed on the buffer layer 502 and has a thickness of 3 $\mu$m, for example. The undoped AlGaN layer 504 is formed on the undoped GaN layer 503 and has a thickness of 30 nm, for example.

The source electrode 505, the gate electrode 506, and the drain electrode 507 are formed on the undoped AlGaN layer 504. The source electrode 505 and the drain electrode 507 each have a layered structure comprising Ti, Al, Ti, and Au, for example. The gate electrode 506 is a layered structure of Au and Ni.

Then, with reference to Fig. 6, a method of manufacturing the HEMT 500 in this embodiment will be described.

Specifically, first, at least one selected from $CH_3NH_2$ and $C_2H_5NH_2$ is used as a N raw material (Step S1). Next, $NH_3$ is prepared as required (Step S2). During the steps, gas containing at least one selected from $CH_3NH_2$ and $C_2H_5NH_2$ as a N raw material can be prepared. Since Steps S1 and S2 are the same as in Embodiments 1 to 4, the descriptions thereof are not repeated.

Next, a substrate is prepared (Step S3). In this embodiment, the substrate 501, such as a sapphire substrate, is prepared as the substrate, for example. According to this embodiment, HEMT 500 may be produced.

Next, the group III-V compound semiconductor is grown using the above-prepared gas by vapor phase growth (Step S4). In this embodiment, the group III-V compound semiconductor is grown, in which the buffer layer 502, the undoped GaN layer 503, and the undoped AlGaN layer 504 are formed in the stated order by, for example, OMVPE. This growth process may be performed by using at least one selected from $CH_3NH_2$ and $C_2H_5NH_2$ as a group V raw material.

Next, the gate electrode 506 is formed on the undopedAlGaN layer 504. The gate electrode 506 has a layered structure comprising Au and Ni. Next, the source electrode 505 and the drain electrode 507 are formed on the undoped AlGaN layer 504. The electrodes 505 and 507 each have a layered structure comprising Ti, Al, Ti, and Au.

By carrying out the above-described Steps S1 to S4, the HEMT 500 shown in Fig. 6 can be manufactured. The use of $NH_3$ causes loss of N at the interface of semiconductor layers or channel layer such as AlGaN and GaN. Because the loss of N affects on operation properties, the obtained devices lose reliability However, by employing the above-described steps, N is not lost, and thus reliability can be improved.

(Embodiment 6)

Figure 7 is a cross sectional view illustrating another embodiment of a vertical transistor as an electron device. As shown in Fig. 7, the transistor 600 is provided with a substrate 601, a drift layer 602, a well region 603, a source region 604, an insulating layer 605, a source electrode 606, a gate electrode 607, and a drain electrode 608.

The substrate 601 is a GaN substrate, for example. The drift layer 602 is formed on the substrate 601. The layer 602 has a thickness of, for example, 5 to 7 $\mu$m and contains a n-type GaN. The well region 603 is formed on the surface of the drift layer 602 and contains a p-type GaN, for example. The source region 604 is formed on the surface of the well region 603 and contains a n-type GaN, for example.

The insulating layer 605 is formed on the drift layer 602, wherein the drift layer 602 contains for example, $SiO_2$ (silicon dioxide). On the insulating layer 605, the gate electrode 607 is formed, and has a layered structure comprising Au and Ni, for example. The source electrode 606 is formed on the source region 604, and has a layered structure comprising Ti, Al, Ti, and Au, for example. The drain electrode 608 is formed on a surface of the substrate 601 opposite to the surface thereof on which the drift layer 602 has been formed, and has a layered structure comprising Ti, Al, Ti, and Au, for example.

Then, with reference to Fig. 7, a method of manufacturing the transistor 600 in this embodiment will be described.

Specifically, first, at least one selected from $CH_3NH_2$ and $C_2H_5NH_2$ is used as a N raw material (Step S1). Next, $NH_3$ is prepared as required (Step S2). During the steps, gas containing at least one selected from $CH_3NH_2$ and $C_2H_5NH_2$ as a N raw material can be prepared. Since Steps S1 and S2 are the same as in Embodiments 1 to 5, the descriptions thereof are not repeated.

Next, a substrate is prepared (Step S3). In this embodiment, the substrate 601, such as a GaN substrate, is prepared as the substrate According to this embodiment, the transistor 600 may be produced.

Next, the group III-V compound semiconductor is grown using the above-prepared gas by vapor phase growth (Step S4). In this embodiment, the group III-V compound semiconductor (drift layer 602) is formed using at least one selected from $CH_3NH_2$ and $C_2H_5NH_2$ as a group V raw material by, for example, OMVPE.

Next, a resist pattern is formed on the drift layer 602 by photolithography. Thereafter, impurities are introduced into a predetermined area of the drift layer 602 by ion implantation to control electrical properties. As electrically conductive impurities, Mg is introduced into the well region 603 and Si is introduced into the source region 604, for example. In this way, the well region 603 and the source region 604 are formed. Next, the insulating layer 605 is formed on the drift layer 602, the well region 603, and the source region 604.

Next, a layered structure comprising Au and Ni is formed on the insulating layer 605 as the gate electrode 607. On the layered structure, a resist pattern is formed by photolithography. Using the resist pattern as a mask, the layered structure comprising Au and Ni, and a film are selectively removed by etching. After this partial removal process, the gate electrode 607 and the insulating layer 605 are formed.

Next, a layer structure comprising Ti, Al, Ti, and Au is formed on the source region 604 as the source electrode 606. Next, a layer structure comprising Ti, Al, Ti, and Au is formed as the drain electrode 608 on a surface of the substrate 601 opposite to the surface thereof on which the drift layer 602 has been formed.

By carrying out the above-described Steps S1 to S4, the transistor 600 shown in Fig. 7 can be manufactured. The use of $NH_3$ causes loss of N at the pn interface. Because the loss of N affects on operation properties, the obtained semiconductor loses reliability. However, by employing the above-described steps, N is not lost, and thus reliability can be improved.

Moreover, when a transistor required to have a thick film is manufactured, the supply amount of the group V elements can be reduced, resulting in advantages in cost in terms of a raw material, elimination, etc.

EXAMPLES

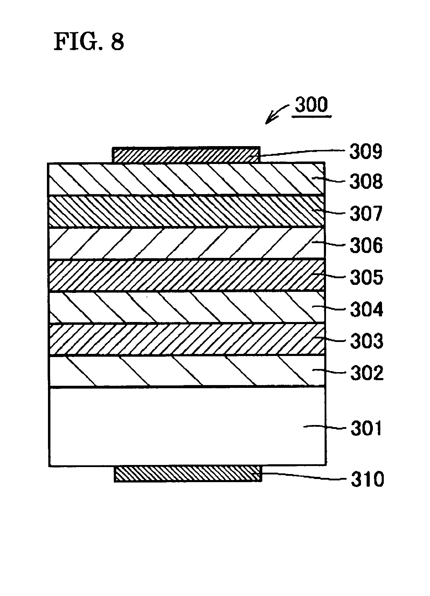

Figure 8 is a cross sectional view illustrating an LD (Laser Diode) in this example. Specifically, as shown in Fig. 8, an LD 300 in this example was provided with a substrate 301, a n-type cladding layer 302, an undoped guide layer 303, an active layer 304, an undoped guide layer 305, a p-type electron blocking layer 306, a p-type cladding layer 307, a p-type contact layer 308, a p-type electrode 309, and a n-type electrode 310.

As the substrate 301, a n-type GaN substrate was used. In this example, properties of the substrates 301 of a c-plane substrate, a non-polar a-plane substrate, an m-plane substrate, and a semipolar substrate (20° off in the a-plane direction relative to the c axis) were compared each other.

These substrates 301 were introduced into an OMVPE apparatus, and were held for 10 minutes at 1,100°C in a $NH_3/H_2$ atmosphere. Thus, the migration of atoms existing on the surface of the substrate 301 was promoted to flatten the surface. Subsequently, on the substrate 301, the n-type cladding layer 302 was formed at 1,050°C, in which the layer 302 has a thickness of 2.3 $\mu$m and contains an n-type $Al_{0.04}Ga_{0.96}N$. It should be noted that the n-type cladding layer 302 was doped with Si, and the carrier concentration was $4 \times 10^{18}/cm^3$. $NH_3$ was supplied as a group V element and the V/III ratio was adjusted to 2,000. Next, on the n-type cladding layer 302, the undoped guide layer 303 was formed at 850°C, in which the layer 303 has a thickness of 50 nm and contains $In_{0.35}Ga_{0.65}N$. $NH_3$ gas was supplied as the group V element. It should be noted that the incorporation amount of In varies according to the type of the substrate 301, and thus the incorporation amount thereof was adjusted with the supply amount of TMI. Next, the active layer 304 was formed on the undoped guide layer 303. The active layer 304 was formed of a multiple quantum well structure having three layers, such as an $In_{0.35}Ga_{0.65}N$ layer (well layer) with a thickness of 3 nm and an $In_{0.06}Ga_{0.94}N$ layer (barrier layer) with a thickness of 15 nm. It should be noted that, in the active layer 304, the well layer was grown at 700°C and the barrier layer was grown at 850°C. As the group V element, monomethylamine ($CH_3NH_2$) was supplied. The V /III ratio was adjusted to 200. Next, on the active layer 304, the undoped guide layer 305 was formed, in which the layer 305 has a thickness of 50 nm and contains an $In_{0.06}Ga_{0.94}N$ layer. As the group V element, $NH_3$ gas was supplied. Next, on the undoped guide layer 305, the p-type electron blocking layer 306 was formed, in which the layer 306 has a thickness of 20 nm and contains p-type $Al_{0.18}Ga_{0.82}N$. Next, on the p-type electron blocking layer 306, the p-type cladding layer 307 was formed in which the layer 307 has a thickness of 2.4 $\mu$m and containing p-type AlGaN. It should be noted that the p-type cladding layer 307 was doped with Mg and the carrier concentration was $2 \times 10^{17}/cm^3$. Next, on the p-type cladding layer 307, the p-type contact layer 308 having a thickness of 50 nm and containing p-type GaN was formed. With respect to all of the p layers, $NH_3$ gas was supplied as the group V element.

The p-type electrode 309 was formed on the p-type contact layer 308. Through this formation, an electrode, in which Ni and Au had been layered, was formed with vacuum deposition. Next, the n-type electrode 310 was formed on a surface of the substrate 301 opposite to the surface thereof on which the n-type cladding layer 302 had been formed. In this process, an electrode, in which Ti, Al, etc., had been layered, was formed by vacuum deposition. Using a conventional photolithography technique and a conventional semiconductor process technique, an LD chip having a ridge width of 1.5 $\mu$m and a resonator length of 600 $\mu$m was manufactured.

By carrying out the above-described steps (S 1 to S4), the LDs 300 shown in Fig. 8 were manufactured. The LDs 300 are each provided with the substrates 301 of a c-plane substrate, an a- non-polar plane substrate, an m-non-polar plane substrate, or a semipolar substrate. It should be noted that the stripe direction was defined as the m-axis direction.

In contrast, as a comparative example, an LD was manufactured using $NH_3$ as the N source of the active layer 304.
A clear peak was not observed in photoluminescence evaluation of the LD 300 in the case of using $NH_3$ as the group V element. This is because precipitation of In and defects occur in the active layer containing InGaN due to a small supply amount of active N.

When $CH_3NH_2$ was used as the group V element, laser oscillation was observed at a wavelength longer than 500 nm. The light emission wavelengths of LDs each provided with a c-plane substrate, a- non-polar plane substrate, an m-non-polar plane substrate, or a semipolar substrate were 500 nm, 520 nm, 520 nm, and 510 nm, respectively. The blue shift amounts thereof (difference between the LED light emission wavelength and the wavelength at 1 mA) were 50 nm, 10 nm, 10 nm, and 15 nm, respectively. The threshold current densities thereof in pulse measurement (pulse width of 5 $\mu$sec, duty 0.1%) were 30 kA/$cm^2$, 18 kA/$cm^2$, 15 kA/$cm^2$, and 22 kA/$cm^2$, respectively. By the use of $CH_3NH_2$, active nitrogen (N) can be supplied even at 700°C, and the obtained InGaN was provided with a high-quality and In composition higher than 30%.

It should be noted that the above-described embodiments and examples are merely examples and are not to be construed as limiting the scope of the present invention. The scope of the present invention is shown not by the aforementioned embodiments but by the scope of claim, and it is intended that all modifications within the meaning and range equivalent to the scope of claim are included.

INDUSTRIAL APPLICABILITY

The method of growing the group III-V compound semiconductor, the method of manufacturing a light-emitting device and an electron device of the present invention may be preferably employed for supplying N as a group V raw material or as a dopant.

Claims

1. A method of growing a group III-V compound semiconductor, comprising:

a process of preparing gas containing at least one selected from the group consisting of monomethylamine and monoethylamine as a nitrogen raw material; and
a process of growing a group III-V compound semiconductor using said gas by vapor phase growth.

2. The method of growing a group III-V compound semiconductor according to claim 1, wherein the group III-V compound semiconductor contains a group III-V nitride semiconductor.

3. The method of growing a group III-V compound semiconductor according to claim 1 or 2, wherein the vapor phase growth method is at least one selected from the group consisting of organo-metallic vapor phase epitaxy, hydride vapor phase epitaxy, and molecular beam epitaxy.

4. The method of growing a group III-V compound semiconductor according to any one of claims 1 to 3, wherein the group III-V compound semiconductor contains indium.

5. The method of growing a group III-V compound semiconductor according to any one of claims 1 to 4, wherein the process of preparing the gas includes a step of preparing ammonia, and the process of growing the group III-V compound semiconductor includes a step of supplying the ammonia at the time of supplying at least one selected from the group consisting of monomethylamine and monoethylamine.

6. The method of growing a group III-V compound semiconductor according to any one of claims 1 to 4, wherein the process of preparing the gas includes a step of preparing ammonia, and the process of growing the group III-V compound semiconductor includes a step of supplying at least one selected from the group consisting of monomethylamine and monoethylamine and a step of supplying ammonia, wherein the steps in the process of growing the group III-V compound semiconductor are interchangeably performed.

7. The method of growing a group III-V compound semiconductor according to any one of claims 1 to 6, wherein the monomethylamine and the monoethylamine each have a $H_2O$ content of 50 ppm or lower.

8. The method of growing a group III-V compound semiconductor according to any one of claims 1 to 7, wherein the process of preparing the gas includes a step of removing $H_2O$ from at least one selected from the group consisting of monomethylamine and the monoethylamine.

9. The method of growing a group III-V compound semiconductor according to any one of claims 1 to 8, wherein the group III-V compound semiconductor contains a p-type semiconductor layer.

10. A method of manufacturing a light-emitting device, comprising:

a stage of growing a group III-V compound semiconductor by the method of growing a group III-V compound semiconductor according to any one of claims 1 to 9.

11. A method of manufacturing an electron device, comprising:

a stage of growing a group III-V compound semiconductor by the method of growing a group III-V compound semiconductor according to any one of claims 1 to 9.

## FIG. 1

```
                                                    ┌─ S1
┌──────────────────────────────────────────────────┐
│  Preparation of at least one of                   │
│  monomethylamine and monoethylamine               │
└──────────────────────────────────────────────────┘
                         │
                         ▼              ┌─ S2
┌──────────────────────────────────────────────────┐
│           Preparation of ammonia                  │
└──────────────────────────────────────────────────┘
                         │
                         ▼              ┌─ S3
┌──────────────────────────────────────────────────┐
│          Preparation of substrate                 │
└──────────────────────────────────────────────────┘
                         │
                         ▼              ┌─ S4
┌──────────────────────────────────────────────────┐
│   Growth of group III-V compound                  │
│             semiconductor                         │
└──────────────────────────────────────────────────┘
```

## FIG. 2

# FIG. 3

```
                                              ┌─ S1
┌──────────────────────────────────────────┐
│       Preparation of at least one of       │
│    monomethylamine and monoethylamine      │
└──────────────────────────────────────────┘
                     │
                     ▼                        ┌─ S2
┌──────────────────────────────────────────┐
│            Preparation of ammonia          │
└──────────────────────────────────────────┘
                     │
                     ▼                        ┌─ S3
┌──────────────────────────────────────────┐
│           Preparation of substrate         │
└──────────────────────────────────────────┘
                     │
                     ▼                        ┌─ S5
┌──────────────────────────────────────────┐
│          Supply of at least one of         │
│    monomethylamine and monoethylamine      │
└──────────────────────────────────────────┘
                     │
                     ▼                        ┌─ S6
┌──────────────────────────────────────────┐
│              Supply of ammonia             │
└──────────────────────────────────────────┘
                     │
                     ▼                        ┌─ S5
┌──────────────────────────────────────────┐
│          Supply of at least one of         │
│    monomethylamine and monoethylamine      │
└──────────────────────────────────────────┘
                     │
                     ▼                        ┌─ S6
┌──────────────────────────────────────────┐
│              Supply of ammonia             │
└──────────────────────────────────────────┘
                     │
                     ▼                        ┌─ S5
┌──────────────────────────────────────────┐
│          Supply of at least one of         │
│    monomethylamine and monoethylamine      │
└──────────────────────────────────────────┘
```

S4

FIG. 4

FIG. 5

FIG. 6

FIG. 7

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H104211 B
- JP S61241913 B
- JP S63103894 B

**Non-patent literature cited in the description**

- **D. Sengupta et al.** *Journal of Crystal growth,* 2005, vol. 279, 375